# EUROPÄISCHE PATENTSCHRIFT

(11) **EP 1 584 904 B1**
(45) Veröffentlichungstag und Bekanntmachung des Hinweises auf die Patenterteilung: **21.05.2008**
(21) Anmeldenummer: 05102192.1
(22) Anmeldetag: 18.03.2005
(51) Int. Cl.: G01J 9/00

(54) **Photomischdetektor**
Photonic mixing device (PMD)
Appareil melangeur photonique (PMD)

(30) Priorität: 05.04.2004 DE 102004016624
(43) Veröffentlichungstag der Anmeldung: 12.10.2005
(73) Patentinhaber: PMDTechnologies GmbH, 57076 Siegen (DE)
(72) Erfinder: XU, Zhanping, 57250, Netphen (DE); MÖLLER, Tobias, 36137, Gro enlüder (DE); KRAFT, Holger, 57078, Siegen (DE); FREY, Jochen, 35578, Wetzlar (DE); ALBRECHT, Martin, 57072, Siegen (DE)
(74) Vertreter: Weber, Roland

(56) Entgegenhaltungen:
- DE-A- 19 821 974

## Beschreibung

Die vorliegende Erfindung betrifft einen Photomischdetektor mit einer photoempfindlichen Schicht, mindestens zwei Modulationsgates und mindestens zwei mit der photoempfindlichen Schicht verbundenen Ausleseelektroden, wobei die Modulationsgates mit einer Modulationseinrichtung verbindbar sind, welche das Potential der Modulationsphotogates relativ zueinander und relativ zu dem vorzugsweise konstanten Potential der Ausleseelektroden entsprechend einer gewünschten Modulationsfunktion anhebt und absenkt.

Aus dem Stand der Technik, beispielsweise der DE 198 21 974 A1 sind Photomischdetektoren und ein Verfahren zum Erfassen von Amplitude und Phase einer elektromagnetischen Welle bekannt. Das aus dem Stand der Technik bekannte Meßprinzip verwendet einen Photodetektor mit einer photoempfindlichen Schicht, in der einfallende Photonen Ladungsträger erzeugen und zwei Ausleseelektroden bzw. Auslesegates, die es ermöglichen, ein der Anzahl der einfallenden Photonen proportionales Strom- oder Spannungssignal aus dem Detektor auszulesen. Zusätzlich sind nahe der Ausleseelektroden Modulationsgates vorgesehen, die mit einer modulierten Spannung vorgespannt werden, um die in der photoempfindlichen Schicht erzeugten Ladungsträger zu den Ausleseelektroden hin zu treiben. Dabei wird an die Modulationsgates ein moduliertes Spannungssignal angelegt, das mit der Modulation, die der zu detektierenden elektromagnetischen Strahlung zuvor als Intensitätsmodulation aufgeprägt wurde, korreliert ist. Dabei weisen die Intensitätsmodulation der einfallenden elektromagnetischen Strahlung und die Modulation der Modulationsgates aus praktischen Gründen im allgemeinen die gleiche Frequenz auf. Entscheidend ist, daß die Modulation der elektromagnetischen Strahlung und die Modulationsspannung der Modulationsgates nicht nur die gleiche Frequenz zeigen, sondern die Signale auch phasenstarr miteinander gekoppelt sind. Das Modulationssignal kann einen kosinus-förmigen Verlauf, aber auch jede andere periodische oder quasiperiodische Struktur haben. Daher kann das an die Modulationsgates angelegte Signal auch als Referenzsignal bezeichnet werden. Dabei weisen die Referenzsignale, die auf die beiden Modulationsgates gegeben werden, eine Phasenverschiebung von 180° zueinander auf, so daß die Modulationsgates in dem Photomischdetektor ein Potentialgefälle hervorrufen, das die erzeugten Ladungsträger zu der einen oder der anderen Ausleseelektrode treibt. Das über die Ausleseelektroden gemessene Spannungs- oder Stromsignal ist eine Funktion des Produktes aus der Anzahl der generierten Ladungsträger und der Modulations- bzw. Referenzspannung. Das gemessene Signal ist dann im wesentlichen proportional zur Intensität der einfallenden elektromagnetischen Welle und ihrer Phasenverschiebung in Bezug auf die Modulationsspannung. Mißt man mit einem zweiten Mischerelement, zweckmäßigerweise auf dem gleichen Photomischdetektor, gleichzeitig die Quadraturkomponente der einfallenden elektromagnetischen Welle, so erhält man aus den beiden aus den Mischerelementen ausgelesenen Werten unmittelbar die Amplituden- und Phaseninformation des einfallenden elektromagnetischen Signals. Dazu müssen die an die Modulationsgates des zweiten Mischerelements angelegten Modulationsspannungen eine Phasenverschiebung zu den Modulationsspannungen des ersten Mischerelements von 90° aufweisen.

Entsprechende Photomischdetektoren sind aus der deutschen Patentanmeldung DE 198 21 974 A1 bekannt und es wird auf die gesamte Offenbarung dieser Voranmeldung Bezug genommen, so weit darin die grundsätzliche Funktionsweise, der Aufbau und die Anwendungsmöglichkeiten der Photomischdetektoren beschrieben sind. Die in der DE 198 21 974 A1 offenbarten Photomischdetektoren weisen mindestens zwei Modulationsgates und mindestens zwei Ausleseelektroden in Form langer und schmaler, paralleler Streifen auf. Die Streifenform der Gates bzw. Elektroden ermöglicht es, die Gatelängen, d.h. die Dimension der Gates in Richtung der Ladungsträgerbewegung, so gering wie möglich zu halten und gleichzeitig eine ausreichend große Fläche zur Ladungsträgererzeugung durch die einfallende elektromagnetische Strahlung bereitzustellen. So läßt sich auch für kurze Gatelängen eine ausreichend hohe Effizienz der Photomischdetektoren erreichen.

Die Ausleseelektroden weisen im allgemeinen metallische Kontakte auf, die direkt auf die photoempfindliche Schicht aufgedampft oder aufgesputtert werden. Die photoempfindliche Schicht besteht aus einem Halbleitermaterial, zum Beispiel p- oder n- dotiertem Silizium. Dabei ist das Halbleitermaterial im Bereich unter den Kontakten komplementär zum restlichen Wafer dotiert. So werden die Ausleseelektroden von pn-Dioden gebildet. Aus dem Stand der Technik sind jedoch auch Photomischdetektoren bekannt, bei denen die metallischen Kontakte auf einem intrinsischen oder durchgängig dotierten Halbleitermaterial aufgebracht sind. Die Ausleseelektroden weisen dann aufgrund des Metall-Halbleiterübergangs ebenfalls eine diodenartige, nicht-ohmsche Kennlinie auf.

Als nachteilig erweist sich, daß die aus dem Stand der Technik bekannten Auslesedioden bzw. diodenartigen Ausleseelektroden in Streifenform eine große Kapazität aufweisen, die die Ladungsträgerkonversionseffizienz (charge conversion efficiency, CCE) bei Verwendung der Spannungsmeßtechnik begrenzen. Dabei bezeichnet man als Ladungsträgerkonversionseffizienz den Spannungsanstieg pro in dem photoempfindlichen Material erzeugtem Ladungsträger.

Darüber hinaus haben die verwendeten streifenförmigen Ausleseelektroden aufgrund ihrer Diodencharakteristik den Nachteil, daß sie erhöhte thermische Dunkelströme zeigen, von denen auch die Anwendung eines Strommeßverfahrens betroffen ist.

Gegenüber diesem Stand der Technik liegt der vorliegenden Erfindung die Aufgabe zugrunde, den bekannten Photomischdetektor so weiter zu entwickeln, daß er eine erhöhte Ladungsträgerkonversionseffizienz und verringerte Dunkelströme zeigt.

Die vorliegende Aufgabe wird dadurch gelöst, daß ein Photomischdetektor mit einer photoempfindlichen Schicht, mindestens zwei Modulationsgates und mindestens zwei mit der photoempfindlichen Schicht verbundenen Ausleseelektroden, wobei die Modulationsgates mit einer Modulationseinrichtung verbindbar sind, welche das Potential der Modulationsphotogates relativ zueinander und relativ zu dem vorzugsweise konstanten Potential der Ausleseelektroden entsprechend einer gewünschten Modulationsfunktion anhebt und absenkt, bereitgestellt wird, wobei die Ausleseelektroden jeweils mindestens zwei im Abstand nebeneinander angeordnete diskrete Elektrodenabschnitte aufweisen.

Die Ladungsträgerkonversionseffizienz des Photomischdetektors im Spannungsmeßbetrieb ist in guter Näherung proportional zum Kehrwert der Kapazität der Ausleseelektroden. Die Kapazität der Ausleseelektroden ist ebenso wie der erzeugte Dunkelstrom eine Funktion der Fläche der Ausleseelektroden. Dies gilt sowohl für die Kapazität der Metall-Halbleiterübergänge zwischen den metallischen Kontakten und dem Substrat als auch für die Kapazität von pn-Übergängen in den Ausleseelektroden. Durch die Verwendung von mindestens zwei im Abstand nebeneinander angeordneten diskreten Elektrodenabschnitten anstelle der durchgehenden streifenförmigen Ausleseelektrode ist die Gesamtfläche der Elektrode reduziert und somit deren Kapazität verringert.

Die Gesamtlänge der Ausleseelektrode entspricht vorzugsweise der Länge der aus dem Stand der Technik bekannten einstückigen Ausleseelektroden.

Dabei ist es zweckmäßig, wenn die Elektrodenabschnitte der Ausleseelektroden in einer Reihe nebeneinander angeordnet sind. Die Anordnung mehrerer Elektrodenabschnitte nebeneinander erlaubt einen effizienten Ladungsträgereinfang in die Elektrode bei reduzierter Kapazität der Elektrode. Dabei müssen für ein effizientes Auslesen der Ausleseelektrode die einzelnen Elektrodenabschnitte elektrisch miteinander verbunden sein, wobei die elektrische Verbindung zwischen den einzelnen Elektrodenabschnitten keine direkte elektrische Verbindung zu der photoempfindlichen Schicht bilden sollte, da sonst die Vorteile der diskreten Elektrodenabschnitte zunichte gemacht würden.

Besonders bevorzugt wird eine Ausführungsform der Erfindung, bei welcher die Ausleseelektroden metallische Kontakte, vorzugsweise Aluminium, aufweisen. Diese können direkt auf die photoempfindliche Schicht aufgedampft oder aufgesputtert sein.

Dabei sind die Ausleseelektroden vorzugsweise als pn-Dioden ausgestaltet, wobei die photoempfindliche Schicht bzw. das Substrat im Bereich unter den Kontakten der Ausleseelektroden komplementär zur Dotierung des restlichen Substrats p- oder n- dotiert ist.

Bevorzugt wird eine Ausführungsform der Erfindung, bei welcher die diskreten Elektrodenabschnitte der Ausleseelektroden maximal das Dreifache, vorzugsweise maximal das Doppelte ihrer Breite beträgt und besonders bevorzugt gleich ihrer Breite ist. Dabei beträgt die Breite der diskreten Elektrodenabschnitte 0,5 bis 5 Mikrometer, vorzugsweise 1 bis 3 Mikrometer und besonders bevorzugt 1,8 Mikrometer.

Bevorzugt wird eine Ausführungsform der Erfindung, bei der die einzelnen Elektrodenabschnitte einer Ausleseelektrode einen Abstand zwischen ihren seitlichen Rändern zwischen 2 Mikrometern und 10 Mikrometern, bevorzugt zwischen 4 Mikrometern und 8 Mikrometern und besonders bevorzugt von 6 Mikrometern aufweisen.

Es ist darüber hinaus zweckmäßig, wenn die metallischen Kontakte der Ausleseelektroden einen T-förmigen Querschnitt aufweisen, so daß sie teilweise über die angrenzenden Materialschichten auskragen. Die so ausgestalteten metallischen Kontakte weisen eine ausreichende Größe zum Kontaktieren auf, während ihre Kontaktfläche zum photoempfindlichen Material möglichst klein ist.

Eine solche Struktur kann effizient in der aus dem Stand der Technik bekannten CMOS-Technologie hergestellt werden. Jedoch sind auch Ausführungsformen in anderen Technologien, z.B. auf GaAs vorteilhaft und ohne Beschränkung der Funktion möglich.

Besonders bevorzugt ist eine Ausführungsform der vorliegenden Erfindung, bei der die Modulationsgates im wesentlichen streifenförmig, d.h. länger als breit sind. Dabei erstrecken sie sich parallel zu den in einer Reihe angeordneten diskreten Elektrodenabschnitten der Ausleseelektroden.

Dabei ist es zweckmäßig, wenn die Modulationsgates für die einfallende elektromagnetische Strahlung transparent sind, so daß die auf den Detektor einfallende Strahlung durch die Modulationsgates hindurch auf die darunter liegende photoempfindliche Schicht trifft. Dabei können die Modulationsgates sowohl von einer transparenten p- oder n- dotierten Halbleiterschicht als auch von einer transparenten metallischen Schicht gebildet werden.

Es ist vorteilhaft, wenn die Modulationsgates mit Hilfe einer elektrischen Isolationsschicht, vorzugsweise einer Oxidschicht, elektrisch von der photoempfindlichen Schicht getrennt sind. So bleibt der Einfluß auf die unter der Isolationsschicht in der photoempfindlichen Schicht erzeugten Ladungsträger erhalten, ohne daß diese von den Modulationsgates eingefangen werden können.

Bevorzugt wird eine Ausführungsform der Erfindung, bei der die Elektrodenabschnitte einer Ausleseelektrode räumlich an die Modulationsgates angrenzen, wobei sie elektrisch von diesen isoliert sind. So läßt sich ein effizienter Ladungsträgereinfang durch die Ausleseelektroden erreichen.

Besonders bevorzugt ist eine Ausführungsform, bei der die Modulationsgates aus p- oder n-dotiertem Halbleitermaterial hergestellt sind.

Dabei ist es zweckmäßig, wenn die Ausleseelektroden an den Seiten, die nicht an die Modulationsgates angrenzen, von einer Isolierschicht umgeben werden.

Besonders bevorzugt wird eine Ausführungsform der vorliegenden Erfindung, bei der die Elektrodenabschnitte einer Ausleseelektrode räumlich im Bereich der Modulationsgates angeordnet sind, wobei sie von diesen elektrisch isoliert sind. So können die Ladungsträger von mindestens drei Seiten auf die Elektrodenabschnitte der Ausleseelektroden auffließen.

Bevorzugt wird eine Ausführungsform der Erfindung, bei der die einzelnen Elektrodenabschnitte einer Ausleseelektrode einen Abstand zwischen ihren seitlichen Rändern zwischen 2 Mikrometern und 10 Mikrometern, bevorzugt zwischen 4 Mikrometern und 8 Mikrometern und besonders bevorzugt von 6 Mikrometern aufweisen. Die angegebenen Abstände ermöglichen eine effiziente Ansammlung der Ladungsträger auf den einzelnen Elektrodenabschnitte der Ausleseelektroden.

Eine besonders kompakte Ausführungsform des erfindungsgemäßen Photomischdetektors wird erhalten, wenn zwei benachbarte Mischerelemente des Detektors eine gemeinsame Ausleseelektrode aufweisen. Dabei können die Elektrodenabschnitte der gemeinsamen Ausleseelektrode entweder räumlich im Bereich eines gemeinsamen Modulationsgates der beiden Detektoren angeordnet sein oder räumlich an zwei getrennte Modulationsgates der beiden Detektoren angrenzen.

Besonders bevorzugt wird eine Ausführungsform der vorliegenden Erfindung, bei der mindestens zwei zusätzliche Speichergates vorgesehen sind, welche die Ausleseelektroden umgeben. Die Speichergates sind vorzugsweise gegen die Ausleseelektroden elektrisch isoliert und mit einer elektrischen Vorspannung versehen. Die Speichergates bilden mindestens zwei die Ausleseelektroden umgebende Potentialtöpfe, in denen sich die von der elektromagnetischen Strahlung erzeugten Ladungsträger nach dem Durchlaufen des von den Modulationsgates erzeugten Potentialgefälles sammeln. Wird als photoempfindliche Schicht ein Halbleiter, wie Silizium, verwendet, so reicht es aus, die Speichergates mit einer positiven Vorspannung zu versehen, so daß ein Potentialtopf für die den Stromfluß bestimmenden Elektronen erzeugt wird.

Vorzugsweise sind die Speichergates mit einer für die einfallende elektromagnetische Strahlung nicht transparenten Schicht abgedeckt, so daß keine Ladungsträger im Bereich der Speichergates erzeugt werden. Darüber hinaus ist es zweckmäßig, wenn die Elektrodenabschnitte der Ausleseelektroden gegenüber den Speichergates elektrisch isoliert sind.

Durch die Kombination der diskreten Elektrodenabschnitte der Ausleseelektroden mit den sie umgebenden vorzugsweise streifenförmigen Speichergates werden die Vorteile der streifenförmigen Ausleseelektroden aus dem Stand der Technik mit denen der diskreten Elektrodenabschnitten der erfindungsgemäßen Ausleseelektroden verbunden. Die streifenförmigen Ausleseelektroden aus dem Stand der Technik ermöglichen einen effizienten Ladungsträgerabfluß, da alle photoerzeugten Ladungsträger, die aufgrund des elektrischen Feldes in einer Richtung senkrecht zu den streifenförmigen Ausleseelektroden beschleunigt werden, auf die Ausleseelektroden treffen und auf diese auffließen können. Ähnlich wie die streifenförmigen Ausleseelektroden sammeln auch die erfindungsgemäßen Speichergates alle in eine Richtung senkrecht zu den Streifen beschleunigten Ladungsträger ein. Das Auslesen erfolgt dann mit Hilfe der diskreten Elektrodenabschnitten der Ausleseelektroden, die eine geringere Auslesekapazität aufweisen als die aus dem Stand der Technik bekannten streifenförmigen Ausleseelektroden. Der Einfang der Ladungsträger aus den Speichergates in die Ausleseelektroden erfolgt ebenfalls sehr effizient.

Darüber hinaus weisen die erfindungsgemäßen Photomischdetektoren mit Speichergates eine zweistufige Ladungsträgerkonversionseffizienz in Abhängigkeit von der Beleuchtungsintensität auf. Bei geringer Beleuchtungsintensität und wenigen photogenerierten Ladungsträgern ist die integrierende Kapazität des Detektors gleich der intrinsischen Kapazität der Metall-Halbleiterkontakte bzw. der pn-Dioden der Ausleseelektroden. Erreichen die Ausleseelektroden durch Auffließen von Ladungsträgern das Potential der Speichergates, so ist die integrierende Kapazität des Detektors gleich der Summe aus der intrinsischen Kapazität der Ausleseelektroden und der Kapazität der Speichergates. Der beschriebene Vorgang führt für niedrige Intensitäten der einfallenden elektromagnetischen Strahlung zu einer hohen Sensitivität bzw. Ladungsträgerkonversionseffizienz, während für hohe Intensitäten (viele photogenerierte Ladungsträger) die Ladungsträgerkonversionseffizienz einen zweiten niedrigeren Wert annimmt. Da die Sensitivität für hohe Intensitäten reduziert ist, erreicht der erfindungsgemäße Photomischdetektor im Vergleich zu den Detektoren ohne Speichergates erst bei höheren Intensitäten eine Sättigung, so daß der dynamische Bereich des Photomischdetektors verbessert ist. Durch Anpassen der Vorspannung der Speichergates ist der Schwellenwert für das Erreichen der reduzierten Konversionseffizienz frei einstellbar.

Die mit einer konstanten Vorspannung versehenen Speichergates verringern das Übersprechen zwischen den Modulationsgates und den Ausleseelektroden des Photomischdetektors. Auf diese Weise wird eine mögliche Störung der Ausleseelektroden aufgrund des Modulationssignals minimiert. Idealerweise erfolgt eine vollständige Abkopplung der Auslesedioden von hochfrequenten Störungen. Daher können die Speichergates auch als "Separationsgates" bezeichnet werden.

Eine besonders kompakte Bauweise wird bei Verwendung eines gemeinsamen Speichergates für zwei benachbarte Mischerelemente des Detektors erreicht.

Besonders bevorzugt wird eine Ausführungsform der Erfindung, bei welcher der Photomischdetektor mindestens eine zusätzliche Speicherstruktur aufweist. Dabei ist die Speicherstruktur zweckmäßigerweise aus mindestens einer Ausleseelektrode mit einem sie umgebenden Speichergate aufgebaut, wobei die Ausleseelektroden aus diskreten, elektrisch miteinander verbundenen Elektrodenabschnitten aufgebaut sind, wobei die Elektrodenabschnitte der Ausleseelektroden elektrisch von den Speichergates isoliert sind, wobei die Speicherstruktur mit einer für elektromagnetische Wellen nicht transparenten Schicht abgedeckt ist und wobei die Ausleseelektroden der Speicherstruktur mit mindestens einer Ausleseelektrode eines Mischerelementes elektrisch verbunden sind.

Dabei ist es vorteilhaft, wenn die Speichergates der Speicherstrukturen auf einem Potential zwischen dem Potential der Speichergates der Mischerelemente und dem Potential der Ausleseelektroden der Mischerelemente liegen.

Die erfindungsgemäße Speicherstruktur erweitert das zuvor für die Speichergates beschriebene Prinzip einer zweistufigen Ladungsträgerkonversionseffizienz durch hinzufügen der zusätzlichen Kapazität der Speicherstruktur auf eine dreistufige Konversionseffizienz. So wird ein Photomischdetektor mit dreistufiger Sensitivität bereitgestellt, der einen weiter verbesserten dynamischen Bereich aufweist.

Dabei ist es zweckmäßig, wenn pro Detektorelement genau zwei Speicherstrukturen vorgesehen sind, deren Ausleseelektroden mit jeweils einer Ausleseelektrode des Detektorelements verbunden sind. So läßt sich eine Erweiterung des dynamischen Bereichs des Detektorelements erreichen.

Darüber hinaus kann es zweckmäßig sein, wenn zwei benachbarte Mischerelemente auf dem gleichen Photomischdetektor eine gemeinsame Speicherstruktur aufweisen.

Besonders bevorzugt wird eine Ausführungsform der Erfindung, bei welcher der Photomischdetektor mehr als ein Mischerelement aufweist. Dabei können die Mischerelemente so verschaltet sein, daß sich ihre Signale addieren, aber sie können auch mit um 90° verschobenen Modulationssignalen versorgt werden, so daß sich die Quadraturkomponenten zur Bestimmung der Phase des einfallenden elektromagnetischen Signals mit einer Messung erfassen lassen.

Weitere Merkmale, Vorzüge und Anwendungsmöglichkeiten der vorliegenden Erfindung werden anhand der folgenden Beschreibung einer bevorzugten Ausführungsform deutlich.
- Figur 1: zeigt eine Ansicht von oben auf ein Detektorelement aus dem Stand der Technik mit streifenförmigen Ausleseelektroden.
- Figur 2: stellt eine Ansicht von oben auf eine erste Ausführungsform des erfindungsgemäßen Photomischdetektors dar.
- Figur 3: zeigt eine vertikale Schnittansicht durch den in Figur 2 dargestellten Photomischdetektor entlang der Linie A-A'.
- Figur 4: zeigt eine Ansicht von oben auf eine zweite Ausführungsform des erfindungsgemäßen Photomischdetektors.
- Figur 5: zeigt eine vertikale Schnittansicht durch den in Figur 4 gezeigten Photomischdetektor entlang der Linie B-B'.
- Figur 6: zeigt die Potentialverteilung der in den Figuren 2 und 4 gezeigten Photomischdetektoren entlang der Linien A-A'.
- Figur 7: zeigt eine Ansicht von oben auf eine dritte Ausführungsform des erfindungsgemäßen Photomischdetektors.
- Figur 8A: zeigt eine Ansicht von oben auf eine weitere Ausführungsform des erfindungsgemäßen Photomischdetektors.
- Figur 8B: zeigt die Potentialverteilung in dem in Figur 8a dargestellten Photomischdetektor entlang der Linie A-A'.
- Figur 9A: zeigt eine weitere Ausführungsform des erfindungsgemäßen Photomischdetektors.
- Figur 9B: zeigt die Potentialverteilung in dem in Figur 9a dargestellten Photomischdetektor entlang der Linien B-B' bzw. A-A'.
- Figur 10: zeigt eine andere Ausführungsform des erfindungsgemäßen Photomischdetektors von oben.
- Figur 11: zeigt eine Ansicht von oben auf eine Ausführungsform des erfindungsgemäßen Photomischdetektors.

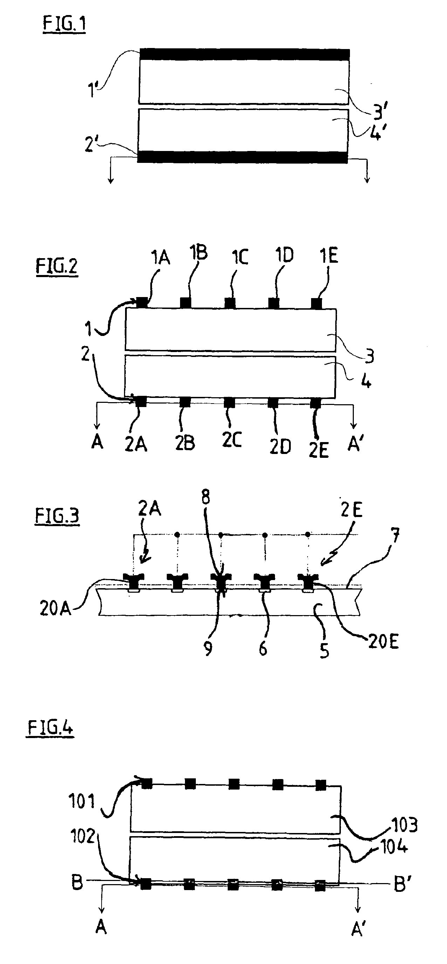

Figur 1 zeigt eine Ansicht von oben auf einen Photomischdetektor, so wie er aus dem Stand der Technik bekannt ist. Deutlich sind die beiden Ausleseelektroden 1', 2' sowie die Modulationsgates 3', 4' des Detektorelements zu erkennen. In der Zeichnung nicht dargestellt ist, daß unter den Gates 1', 2', 3', 4' eine photoempfindliche Schicht aus Silizium angeordnet ist. Im Betrieb werden die Ausleseelektroden 1', 2' mit einer positiven Vorspannung versehen, so daß die Elektroden bzw. Gates als Potentialtopf für die in der photoempfindlichen Schicht erzeugten Ladungsträger wirken. Die positive Vorspannung wird gewählt, da aufgrund der niedrigeren Beweglichkeiten der Löcher ihr Beitrag zum Stromtransport vernachlässigbar ist. An die Modulationsgates 3', 4' wird eine Referenzspannung U_{ref} angelegt, deren Modulation identisch mit der Modulation der einfallenden elektromagnetischen Strahlung ist. Dabei können die Modulation der elektromagnetischen Strahlung und die modulierte Spannung der Modulationsgates 3', 4' eine Phasenverschiebung Φ aufweisen. Bei Beleuchtung mit der intensitätsmodulierten Strahlung werden in der photoempfindlichen Schicht Ladungsträger erzeugt, die nachfolgend im Potentialgefälle, das von den Modulationsgates 3', 4' hervorgerufen wird, zu den Ausleseelektroden 1', 2' hin beschleunigt werden. Dabei ist es notwendig, daß die beiden Modulationsgates mit einem gegenphasigen Modulationssignal vorgespannt werden, um eine Potentialdifferenz zwischen den beiden unter den Modulationsgates 3', 4' liegenden Bereichen der photoempfindlichen Schicht zu erzeugen. Die Anzahl der auf die Ausleseelektroden 1', 2' gelangenden Ladungsträger ist eine Funktion der Intensität der einfallenden elektromagnetischen Strahlung sowie der Phasendifferenz Φ. So läßt sich die Intensität der einfallenden elektromagnetischen Strahlung sowie die Phasendifferenz Φ zwischen dem Modulationssignal der einfallenden elektromagnetischen Strahlung und dem Modulationssignal der Modulationsgates 3', 4' mit Hilfe einer Spannungs- bzw. Strommessung erfassen.

Die Ausleseelektroden 1', 2' weisen ohmsche Kontakte aus Aluminium auf, welche direkt auf das Halbleitermaterial, im dargestellten Fall p-dotiertes Silizium, aufgebracht sind. Im Bereich unter den metallischen Kontakten ist das Halbleitermaterial komplementär zum restlichen Material n⁺-dotiert, so daß die Ausleseelektroden von pn-Dioden gebildet werden. Wird statt dessen ein n-dotiertes Halbleitermaterial verwendet, so ist das Material im Bereich unter den Kontakten der Ausleseelektroden 1', 2' p-dotiert.

In der Draufsicht in Figur 1 sind nur die Grundflächen der komplementär dotierten Bereiche der Ausleseelektroden dargestellt. Die darüberliegende Struktur der Streifen ist von sekundärer Bedeutung. Sollen die Ausleseelektroden mit einer Spannungsmessung ausgelesen werden, so ist das gemessene Spannungssignal proportional zu 1/C_{A}, wobei C_{A} die Kapazität der Ausleseelektroden ist. Die pn-Übergänge der Ausleseelektroden 1', 2' weisen eine intrinsische Kapazität auf, die im wesentlichen die Kapazität C_{A} der Ausleseelektroden bestimmt. Um eine möglichst große Spannungsänderung aufgrund der in dem Photomischdetektor erzeugten Ladungsträger zu erhalten, muß die intrinsische Kapazität der Ausleseelektroden möglichst klein gehalten werden.

Figur 2 zeigt eine erste bevorzugte Ausführungsform des erfindungsgemäßen Photomischdetektors, bei dem die Ausleseelektroden 1, 2 aus diskreten Elektrodenabschnitten 1A - I, 2A - I aufgebaut sind. So ist die Kapazität einer jeden Ausleseelektrode 1, 2 kleiner als die einer streifenförmigen Ausleseelektrode 1', 2' mit einer Länge, die im wesentlichen dem Abstand zwischen den beiden am weitesten auseinanderliegenden diskreten Elektrodenabschnitten 1A, 1E bzw. 2A, 2E entspricht. Die Elektroden der Ausleseelektroden 1, 2 grenzen räumlich direkt an die Modulationsgates, wobei sie in der dargestellten Ausführungsform von den Modulationsgates elektrisch isoliert sind.

Figur 3 zeigt eine Schnittansicht entlang der Linie A-A' aus Figur 2, wobei der Schnitt genau durch die diskreten Elektroden verläuft. Deutlich ist der vertikale Aufbau der Elektrodenabschnitte 2A - 2E zu erkennen. Die photoempfindliche Schicht ist ein p-dotiertes Substrat 5 aus Silizium. Wie in der Schnittansicht in Figur 3 angedeutet, weist das Substrat im Bereich der Elektrodenabschnitte jeweils eine n⁺-Dotierung 6 auf, so daß die Elektrodenabschnitte 2A-2E von pn-Dioden mit darüberliegenden Metallkontakten 20A - 20E gebildet werden. Wird statt dessen ein n-dotiertes Halbleitersubstrat verwendet, so ist das Material im Bereich der Elektrodenabschnitte p-dotiert. Die ohmschen Kontakte sind direkt auf das komplementär dotierte Gebiet 6 aufgebracht.

Zwischen den Elektroden bzw. um sie herum ist eine Siliziumoxidschicht 7 auf dem Substrat 5 angeordnet. Die Kontakte 20A - 20E weisen jeweils einen T-förmigen Querschnitt auf. Die Grundfläche 9 der komplementär dotierten Bereiche 6 der Elektrodenabschnitte 1A - 2E bzw. 2A - 1 E ist quadratisch mit einer Seitenlänge von 1,8 Mikrometern. Aus Figur 3 wird auch deutlich, daß die in den Figuren 2 und 4 bzw. auch in den nachfolgenden Figuren angedeuteten Elektrodenabschnitte der Ausleseelektroden nur die Grundflächen 9 der komplementär dotierten Bereiche 6 der Elektrodenabschnitte darstellen.

Die in Figur 4 gezeigte Anordnung der diskreten Elektrodenabschnitte 101A bis 101E, 102A bis 102E unterscheidet sich von der in Figur 2 gezeigten Anordnung dadurch, daß sich die Elektrodenabschnitte bis in den Bereich der Modulationsgates 103, 104 erstrecken. Dabei sind die Modulationsgates 103, 104 wie zuvor von den Ausleseelektroden elektrisch isoliert. Diese Anordnung erlaubt einen verbesserten Fluß der Ladungsträger auf die Elektrodenabschnitte, im wesentlichen von drei Seiten 110, 111, 112, sowie dies für die Elektrode 102C angedeutet ist.

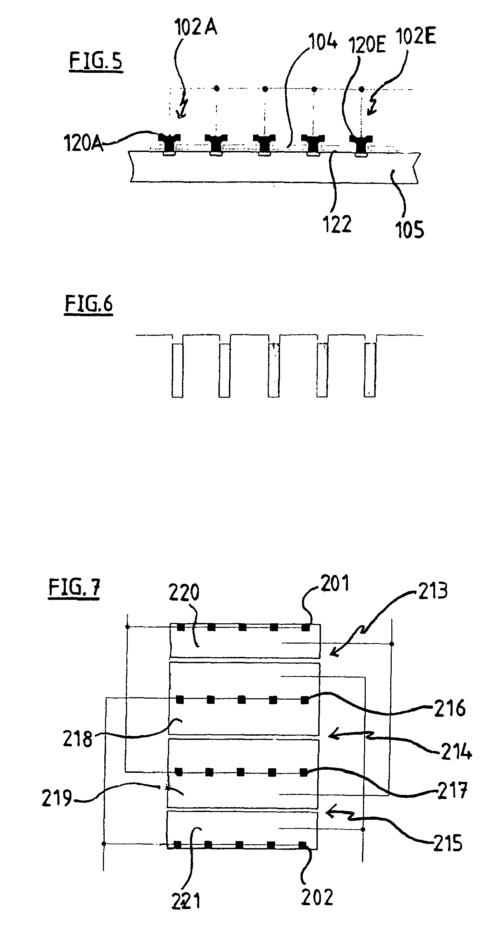

Figur 5 zeigt eine seitliche Schnittansicht durch den in Figur 4 dargestellten Photomischdetektor entlang der Linie B-B'. Deutlich ist zu erkennen, daß die Elektrodenabschnitte 102A bis 102E in den Bereich der Modulationsgates 104 hineinragen, wobei die Modulationsgates gegenüber den Elektrodenabschnitten 102A bis 102E bzw. deren Kontakten 120A bis 120E elektrisch isoliert sind bzw. zu diesen beabstandet sind. Ebenfalls ist in der Schnittansicht gut zu erkennen, daß das Modulationsgate 104 durch eine Siliziumoxidschicht 122 von dem darunterliegenden p-dotierten Siliziumsubstrat getrennt ist. Dabei dient die Siliziumoxidschicht 122 als elektrische Isolierung zwischen dem Modulationsgate 104 und dem Siliziumsubstrat 105.

Figur 6 zeigt den Potentialverlauf in den beiden in den Figuren 2 und 4 dargestellten Photomischdetektoren entlang der Linien A-A'. Deutlich ist zu erkennen, daß die Elektrodenabschnitte der Ausleseelektroden 1, 2, 101, 102 aufgrund ihrer positiven Vorspannung Potentialtöpfe bilden, von denen die photogenerierten Elektronen eingefangen werden können.

Figur 7 zeigt einen aus drei Mischerelementen 213, 214, 215 zusammengesetzten Photomischdetektor. Jedes der Mischerelemente 213 bis 215 weist zwei Ausleseelektroden 201, 202, 216, 217 auf. Dabei ist jede dieser Ausleseelektroden aus jeweils fünf diskreten Elektrodenabschnitten aufgebaut, so wie diese aus den Figuren 2 und 4 bekannt sind.

Die Mischerelemente 213 und 215 verwenden jeweils eine Ausleseelektrode 216 bzw. 217 gemeinsam mit dem zwischen diesen beiden Elementen angeordneten Mischerelement 214. Die von den Mischerelementen 213 bis 215 gemeinsam verwendeten Ausleseelektroden 216 bzw. 217 sind im Bereich zweier großflächiger Modulationsgates 218 und 219 angeordnet. Die beiden Modulationsgates 218 und 219 sind jeweils im wesentlichen doppelt so breit wie die Modulationsgates der in den Figuren 2 und 4 gezeigten Photomischdetektoren. Die Modulationsgates 218 und 219 werden ebenso wie die Ausleseelektroden 216 und 217 von jeweils zwei benachbarten Photomischelementen gemeinsam verwendet. Die Modulationsgates 218 bis 221 sind so verschaltet, daß die jeweils benachbarten Modulationsgates gegenphasig mit dem Modulationssignal beaufschlagt sind. Jeweils zwei der vier Ausleseelektroden 201, 202, 216, 217 werden miteinander verbunden und gemeinsam ausgelesen. Dabei sind immer solche zwei Gates miteinander verbunden, die zu Modulationsgates benachbart angeordnet sind, welche mit einem gleichphasigen Modulationssignal versorgt werden.

Die beiden äußeren Ausleseelektroden 201 und 202 der Detektorelemente 213 bzw. 215 sind wie die in der Figur 4 gezeigten Ausleseelektroden 201 bzw. 202 aufgebaut, jedoch liegen die in Figur 7 gezeigten Ausleseelektroden 201 und 202 vollständig im Bereich der Modulationsgates 220 und 221 und nicht nur zur Hälfte wie die Modulationsgates 201 und 202 in Figur 4.

In alternativen Ausführungsformen können, anders als in Figur 7 gezeigt, auch mehr als drei Mischerelemente zu einem Photomischdetektor verschaltet sein. Auch ist es möglich, auf einem Photomischdetektor zwei dreifache Mischerelemente aus Figur 7 nebeneinander anzuordnen, wobei die Modulationssignale der beiden dreifachen Mischerelemente eine Phasenverschiebung von 90° zueinander aufweisen, so daß sich mit einer einzigen Messung die Quadraturkomponenten und damit gleichzeitig die Intensität und die Phase der einfallenden elektromagnetischen Strahlung erfassen lassen.

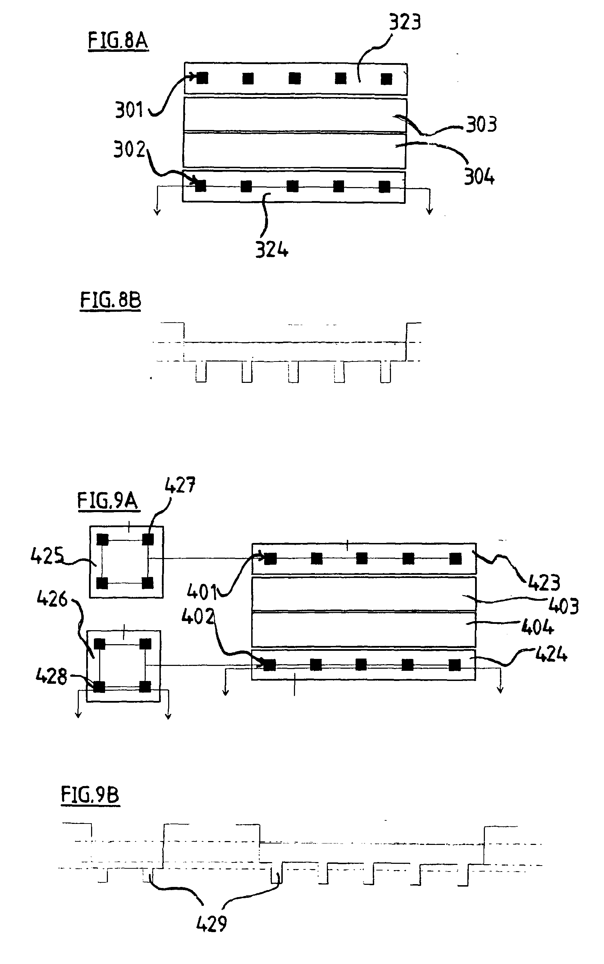

In Figur 8A ist eine weitere alternative Ausführungsform des Photomischdetektors dargestellt. Die Ausleseelektroden 301 und 302 sind von zusätzlichen Speichergates 323 und 324 umgeben, die an die Modulationsgates 303 und 304 angrenzen. Die Speichergates 323 und 324 sind mit einer positiven Gleichspannung vorgespannt, weshalb sich die in Figur 8B dargestellte Potentialverteilung entlang der Linie A-A' aus Figur 8A ausbildet. Die Betriebsvorspannung ist so gewählt, daß der von dem Speichergate in dem darunterliegenden Siliziumsubstrat erzeugte Potentialtopf auf einem höheren Potential liegt als die Elektroden der Ausleseelektrode 302. Die Speichergates bilden einen großen Potentialtopf für die photogenerierten Elektronen. Die Potentialverteilung in bzw. um die Ausleseelektroden 301 und 302 hat zur Folge, daß bei geringer Beleuchtung die Ladungsträger aufgrund der geringen intrinsischen Kapazität der geteilten Diode einen großen Spannungshub hervorrufen. Werden dem gegenüber bei starker Beleuchtung des Photomischdetektors viele Elektronen erzeugt, so füllen diese die Potentialtöpfe der Ausleseelektroden schnell auf und die weiteren Elektronen werden in den Speichergates 323 und 324 gesammelt, wo sie aufgrund der großen Kapazität der Speichergates nur einen geringen Spannungshub pro Ladungsträger erzeugen. Dies führt zusammenfassend dazu, daß bei niedrigen Intensitäten eine hohe Sensitivität zur Verfügung steht, während diese nach dem Überschreiten eines bestimmten durch die Vorspannung des Speichergates vorgegebenen Schwellenwerts der Intensität einen niedrigen Wert annimmt. Auf diese Weise ist der dynamische Bereich des erfindungsgemäßen Photomischdetektors erheblich größer als der eines Photomischdetektors ohne Speichergates.

Figur 9A zeigt eine erweiterte Variante des Photomischdetektors mit Speichergates 423 und 424, wobei neben dem eigentlichen Mischerelement zwei zusätzliche Speicherstrukturen mit weiteren Speichergates 425 und 426 auf dem Siliziumsubstrat angeordnet sind. Dabei sind die zusätzlichen Speichergates 425, 426 elektrisch sowohl voneinander als auch von den restlichen Gates des Photomischdetektors getrennt. Im Bereich der zusätzlichen Speichergates 425, 426 sind ebenfalls Ausleseelektroden 427, 428 angeordnet, die aus diskreten, punktförmigen Elektroden aufgebaut sind. Dabei sind diese Ausleseelektroden 427, 428 elektrisch mit den Ausleseelektroden 401 bzw. 402 verbunden. Die zusätzlichen Speichergates 425, 426 mit den Ausleseelektroden 427, 428 sind mit einer metallischen Schicht abgedeckt, so daß auf sie keine elektromagnetische Strahlung einfällt (in Figur 9A nicht dargestellt). Die zusätzlichen Speichergates 425, 426 sind ebenfalls mit einer Gleichspannung vorgespannt. Dabei ist der Betrag der Vorspannung der zusätzlichen Speichergates 425, 426 größer als der Betrag der Vorspannung der Speichergates 423 und 424.

Die Funktionsweise der zusätzlichen Speichergates 425, 426 wird anhand der Figur 9B deutlich, die den Potentialverlauf entlang der Linien B-B' bzw. A-A' aus Figur 9A darstellt. Deutlich sind wieder die von den Elektroden der Ausleseelektroden gebildeten Potentialtöpfe 429 zu erkennen. Die zusätzliche Kapazität der Speicherstrukturen mit den Speichergates 425, 426 bildet eine weitere, dritte Stufe für die Konversionseffizienz des Photomischdetektors in Abhängigkeit von der eingestrahlten Intensität. Aufgrund der intensitätsabhängigen Konversionseffizienz bzw. Sensitivität zeigt diese Ausführungsform des Detektors einen deutlich vergrößerten dynamischen Bereich.

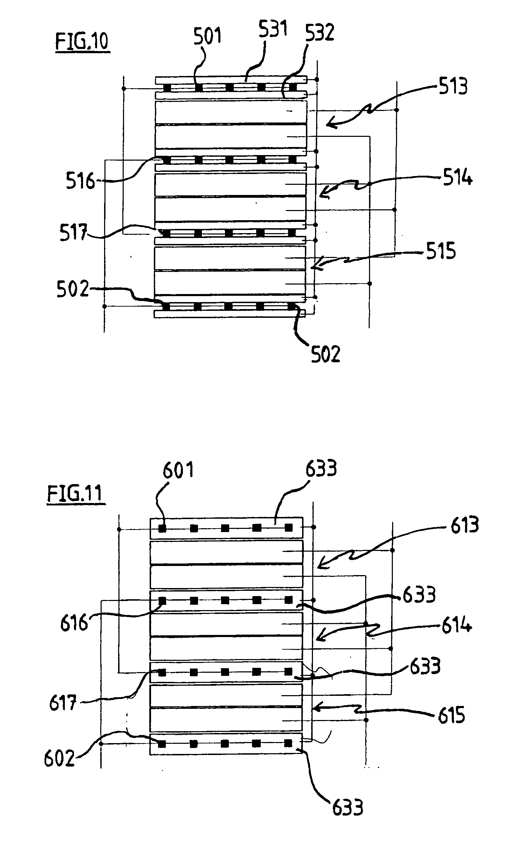

Die Figuren 10 und 11 zeigen zwei Ausführungsformen für die Integration von drei Detektorelementen 513 bis 515 bzw. 613 bis 615 zu jeweils einem Photomischdetektor, wobei die Ausleseelektroden 501, 502, 516, 517 bzw. 601, 602, 616, 617 jeweils von einem Speichergate umgeben sind. Die beiden Ausführungsformen unterscheiden sich dadurch, daß bei der in Figur 10 gezeigten Variante die Speichergates in Form von zwei schmalen Streifen 531, 532 zwischen den Ausleseelektroden und den jeweils zugehörigen Modulationsgates vorgesehen sind, während bei der in Figur 11 gezeigten Variante die Ausleseelektroden innerhalb eines breiteren Speichergates 633 angeordnet sind.

Die in den Figuren 8A, 9A, 10 und 11 dargestellten Speichergates 323, 324, 423, 424, 531, 532, 633 bewirken aufgrund ihrer konstanten Vorspannung eine Verringerung des elektrischen Übersprechens zwischen den Modulationsgates 303, 304, 403, 404 und den Ausleseelektroden 301, 302, 401, 402, 501, 502, 516 und 517. Auf diese Weise sind die Ausleseelektroden vollständig von den störenden Einflüssen der hochfrequenten Modulationsspannung an den Modulationsgates 303, 304, 403, 404 entkoppelt.

## Patentansprüche

1. Photomischdetektor mit einer photoempfindlichen Schicht, mindestens zwei Modulationsgates (3, 4, 103, 104, 203, 204, 303, 304, 403, 404) und mindestens zwei mit der photoempfindlichen Schicht verbundenen Ausleseelektroden (1, 2, 101, 102, 201, 202, 301, 302, 401, 402, 501, 502, 601, 602), wobei die Modulationsgates (3, 4, 103, 104, 203, 204, 303, 304, 403, 404) mit einer Modulationseinrichtung verbindbar sind, welche das Potential der Modulationsgates relativ zueinander und relativ zu dem vorzugsweise konstanten Potential der Ausleseelektroden entsprechend einer gewünschten Modulationsfunktion anhebt und absenkt, **dadurch gekennzeichnet, daß** die Ausleseelektroden (1, 2, 101, 102, 201, 202, 301, 302, 401, 402, 501, 502, 601, 602) jeweils mindestens zwei im Abstand nebeneinander angeordnete diskrete Elektrodenabschnitte (1A-1E, 2A-2E) aufweisen.

2. Photomischdetektor nach Anspruch 1, **dadurch gekennzeichnet, daß** die Ausleseelektroden (1, 2, 101, 102, 201, 202, 301, 302, 401, 402, 501, 502, 601, 602) metallische Kontakte (20A-20E), vorzugsweise aus Aluminium, aufweisen.

3. Photomischdetektor nach Anspruch 1 oder 2, **dadurch gekennzeichnet, daß** die photoempfindliche Schicht im Bereich unter den metallischen Kontakten der Ausleseelektroden (1, 2, 101, 102, 201, 202, 301, 302, 401, 402, 501, 502, 601, 602) komplementär zur restlichen photoempfindlichen Schicht dotiert ist.

4. Photomischdetektor nach einem der Ansprüche 1 bis 3, **dadurch gekennzeichnet, daß** die Ausleseelektroden (1, 2, 101, 102, 201, 202, 301, 302, 401, 402, 501, 502, 601, 602) pn-Dioden sind.

5. Photomischdetektor nach einem der Ansprüche 1 bis 4, **dadurch gekennzeichnet, daß** die Länge der diskreten Elektrodenabschnitte (1A-1E, 2A-2E) der Ausleseelektroden (1, 2, 101, 102, 201, 202, 301, 302, 401, 402, 501, 502, 601, 602) maximal das Dreifache, vorzugsweise maximal das Doppelte ihrer Breite beträgt und besonders bevorzugt gleich ihrer Breite ist.

6. Photomischdetektor nach einem der Ansprüche 1 bis 5, **dadurch gekennzeichnet, daß** die Breite der diskreten Elektrodenabschnitte 0,5 Mikrometer bis 5 Mikrometer, vorzugsweise 1 Mikrometer bis 3 Mikrometer und besonders bevorzugt 1,8 Mikrometer beträgt.

7. Photomischdetektor nach einem der Ansprüche 1 bis 6, **dadurch gekennzeichnet, daß** die einzelnen Elektrodenabschnitte einer Ausleseelektrode (1, 2, 101, 102) einen Abstand zwischen ihren seitlichen Rändern zwischen 2 Mikrometern und 10 Mikrometern, bevorzugt zwischen 4 Mikrometern und 8 Mikrometern und besonders bevorzugt von 6 Mikrometern aufweisen.

8. Photomischdetektor nach einem der Ansprüche 1 bis 7, **dadurch gekennzeichnet, daß** der Querschnitt der Kontakte der Ausleseelektroden (1, 2, 101, 102, 201, 202, 301, 302, 401, 402, 501, 502, 601, 602) T-förmig ist, wobei die Kontakte teilweise über die angrenzenden Materialschichten auskragen.

9. Photomischdetektor nach einem der Ansprüche 1 bis 8, **dadurch gekennzeichnet, daß** die diskreten Elektrodenabschnitte (1A-1E, 2A-2E) jeweils einer Ausleseelektrode (1,2, 101, 102) elektrisch miteinander verbunden sind.

10. Photomischdetektor nach einem der Ansprüche 1 bis 9, **dadurch gekennzeichnet, daß** die Modulationsgates (3, 4, 103, 104) von zueinander parallelen Streifen gebildet werden, die vorzugsweise auch zu den Reihen der diskreten Elektrodenabschnitte der Ausleseelektroden im wesentlichen parallel verlaufen.

11. Photomischdetektor nach einem der Ansprüche 1 bis 10, **dadurch gekennzeichnet, daß** die Modulationsgates (3, 4, 103, 104) für die einfallende elektromagnetische Strahlung transparent sind.

12. Photomischdetektor nach einem der Ansprüche 1 bis 11, **dadurch gekennzeichnet, daß** die Modulationsgates (3, 4, 103, 104) aus einem p- bzw. n-dotierten Halbleitermaterial bestehen.

13. Photomischdetektor nach einem der Ansprüche 1 bis 12, **dadurch gekennzeichnet, daß** die Modulationsgates (3, 4, 103, 104) elektrisch von der lichtempfindlichen Schicht isoliert sind.

14. Photomischdetektor nach Anspruch 13, **dadurch gekennzeichnet, daß** die Modulationsgates (102A-102E) durch eine Silizium-Oxydschicht (122) elektrisch von der lichtempfindlichen Schicht (105) isoliert sind.

15. Photomischdetektor nach einem der Ansprüche 1 bis 14, **dadurch gekennzeichnet, daß** die Elektrodenabschnitte (1A-1 E, 2A-2E) einer Ausleseelektrode (1, 2) räumlich an die Modulationsgates (3, 4) angrenzen.

16. Photomischdetektor nach einem der Ansprüche 1 bis 15, **dadurch gekennzeichnet, daß** zwischen den Kontakten der Elektrodenabschnitte einer jeden Ausleseelektrode (1, 2) eine elektrische Isolationsschicht (7) vorgesehen ist.

17. Photomischdetektor nach einem der Ansprüche 1 bis 16, **dadurch gekennzeichnet, daß** die Elektrodenabschnitte einer Ausleseelektrode (101, 102) räumlich im Bereich der Modulationsgates (103, 104) angeordnet sind.

18. Photomischdetektor nach Anspruch 1 bis 17, **dadurch gekennzeichnet, daß** die Kontakte der Ausleseelektroden (101, 102) elektrisch von den Modulationsgates (103, 104) isoliert sind.

19. Photomischdetektor nach einem der Ansprüche 1 bis 18, **dadurch gekennzeichnet, daß** zwei benachbarte Mischerelemente (213, 214, 215) des Detektors eine gemeinsame Ausleseelektrode (216, 217) aufweisen.

20. Photomischdetektor nach einem der Ansprüche 1 bis 19, **dadurch gekennzeichnet, daß** zwei benachbarte Mischerelemente (213, 214, 215) des Detektors ein gemeinsames Modulationsgate (218, 219) aufweisen.

21. Photomischdetektor nach einem der Ansprüche 1 bis 20, **dadurch gekennzeichnet, daß** mindestens zwei Speichergates (323, 324) vorgesehen sind, welche die Ausleseelektroden (301, 302) umgeben.

22. Photomischdetektor nach Anspruch 21, **dadurch gekennzeichnet, daß** die Speichergates (323, 324, 423, 424) streifenförmig sind.

23. Photomischdetektor nach Anspruch 21 oder 22, **dadurch gekennzeichnet, daß** die Speichergates (323, 324, 423, 424) mit einem für die einfallende elektromagnetische Strahlung nicht transparenten Material abgedeckt sind.

24. Photomischdetektor nach einem der Ansprüche 21 bis 23, **dadurch gekennzeichnet, daß** die Speichergates (323, 324, 423, 424) elektrisch von den Ausleseelektroden (301, 302, 401, 402) isoliert sind.

25. Photomischdetektor nach einem der Ansprüche 21 bis 24, **dadurch gekennzeichnet, daß** die Speichergates (323, 324, 423, 424) elektrisch von der photoempfindlichen Schicht isoliert sind.

26. Photomischdetektor nach einem der Ansprüche 21 bis 25, **dadurch gekennzeichnet, daß** die Speichergates (323, 324, 423, 424) mit einer regelbaren Spannungsquelle verbunden sind.

27. Photomischdetektor nach einem der Ansprüche 21 bis 26, **dadurch gekennzeichnet, daß** die Speichergates (323, 324, 423, 424) mit einer positiven oder negativen elektrischen Spannung vorgespannt sind.

28. Photomischdetektor nach einem der Ansprüche 21 bis 27, **dadurch gekennzeichnet, daß** die Speichergates (323, 324, 423, 424, 531, 532, 633) jeweils ein Separationsgate bilden.

29. Photomischdetektor nach einem der Ansprüche 21 bis 28, **dadurch gekennzeichnet, daß** die Speichergates (323, 324, 423, 424) auf einem anderen Potential liegen als die Ausleseelektroden (301, 302, 401, 402).

30. Photomischdetektor nach einem der Ansprüche 21 bis 29, **dadurch gekennzeichnet, daß** zwei benachbarte Mischerelemente (613, 614, 615) des Detektors ein gemeinsames Speichergate (633) aufweisen.

31. Photomischdetektor nach einem der Ansprüche 1 bis 30, **dadurch gekennzeichnet, daß** er mindestens eine zusätzliche Speicherstruktur aufweist.

32. Photomischdetektor nach Anspruch 31, **dadurch gekennzeichnet, daß**
- die Speicherstruktur mindestens eine Ausleseelektrode (427, 428) mit einem sie umgebenden Speichergate (425, 426) aufweist,
- wobei die Ausleseelektroden (427, 428) diskrete elektrisch miteinander verbundene Elektrodenabschnitte aufweist,
- wobei die Elektroden der Ausleseelektroden (427, 428) elektrisch von den Speichergates (425, 426) isoliert sind,
- wobei die Speicherstruktur mit einer für elektromagnetische Strahlung nicht transparenten Schicht abgedeckt ist, und
- wobei die Ausleseelektroden (427, 428) der Speicherstruktur mit den Ausleseelektroden (401, 402) der Mischerelemente elektrisch verbunden sind.

33. Photomischdetektor nach Anspruch 31 oder 32, **dadurch gekennzeichnet, daß** genau zwei Speicherstrukturen pro Mischerelement vorgesehen sind.

34. Photomischdetektor nach einem der Ansprüche 31 bis 33, **dadurch gekennzeichnet, daß** zwei benachbarte Mischerelemente des Detektors eine gemeinsame Speicherstruktur aufweisen.

35. Photomischdetektor nach einem der Ansprüche 31 bis 34, **dadurch gekennzeichnet, daß** die Speichergates (425, 426) mit einer zweiten regelbaren Spannungsquelle verbunden sind.

36. Photomischdetektor nach einem der Ansprüche 31 bis 35, **dadurch gekennzeichnet, daß** die Speichergates (423, 424) der Mischerelemente auf einem anderen Potential liegen als die Speichergates (425, 426) der Speichereinrichtungen.

37. Photomischdetektor nach einem der Ansprüche 31 bis 36, **dadurch gekennzeichnet, daß** die Speichergates (425, 426) der Speicherstrukturen auf einem niedrigeren Potential liegen als die Speichergates (423, 424) der Mischerelemente und auf einem höheren Potential als die Ausleseelektroden (401, 402) der Mischerelemente.

## Claims

1. Photonic mixer device with a photosensitive layer, at least two modulation gates (3, 4, 103, 104, 203, 204, 303, 304, 403, 404) and at least two readout electrodes (1, 2, 101, 102, 201, 202, 301, 302, 401, 402, 501, 502, 601, 602) connected to the photosensitive layer, the modulation gates (3, 4, 103, 104, 203, 204, 303, 304, 403, 404) being able to be connected to a modulation device which raises and lowers the potential of the modulation gates relative to one another and relative to the preferably constant potential of the readout electrodes corresponding to a desired modulation function, **characterized in that** the readout electrodes (1, 2, 101, 102, 201, 202, 301, 302, 401, 402, 501, 502, 601, 602) in each case have at least two discrete electrode sections (1A - 1E, 2A - 2E) arranged at a distance alongside each other.

2. Photonic mixer device according to claim 1, **characterized in that** the readout electrodes (1, 2, 101, 102, 201, 202, 301, 302, 401, 402, 501, 502, 601, 602) have metal contacts (20A - 20E), preferably of aluminium.

3. Photonic mixer device according to claim 1 or 2, **characterized in that** the photosensitive layer in the area beneath the metal contacts of the readout electrodes (1, 2, 101, 102, 201, 202, 301, 302, 401, 402, 501, 502, 601, 602) is doped complementarily to the remaining photosensitive layer.

4. Photonic mixer device according to one of claims 1 to 3, **characterized in that** the readout electrodes (1, 2, 101, 102, 201, 202, 301, 302, 401, 402, 501, 502, 601, 602) are pn diodes.

5. Photonic mixer device according to one of claims 1 to 4, **characterized in that** the length of the discrete electrode sections (1A - 1 E, 2A - 2E) of the readout electrodes (1, 2, 101, 102, 201, 202, 301, 302, 401, 402, 501, 502, 601, 602) is at most three times, preferably at most twice, their width and particularly preferably equal to their width.

6. Photonic mixer device according to one of claims 1 to 5, **characterized in that** the width of the discrete electrode sections is 0.5 micrometres to 5 micrometres, preferably 1 micrometre to 3 micrometres and particularly preferably 1.8 micrometres.

7. Photonic mixer device according to one of claims 1 to 6, **characterized in that** the individual electrode sections of a readout electrode (1, 2, 101, 102) have a distance between their lateral edges of between 2 micrometres and 10 micrometres, preferably between 4 micrometres and 8 micrometres and particularly preferably of 6 micrometres.

8. Photonic mixer device according to one of claims 1 to 7, **characterized in that** the cross-section of the contacts of the readout electrodes (1, 2, 101, 102, 201, 202, 301, 302, 401, 402, 501, 502, 601, 602) is T-shaped, the contacts projecting partly over the adjoining material layers.

9. Photonic mixer device according to one of claims 1 to 8, **characterized in that** the discrete electrode sections (1A - 1 E, 2A - 2E) of each readout electrode (1, 2, 101, 102) are in each case electrically connected to each other.

10. Photonic mixer device according to one of claims 1 to 9, **characterized in that** the modulation gates (3, 4, 103, 104) are formed of strips running parallel to each other which preferably also run essentially parallel to the rows of the discrete electrode sections of the readout electrodes.

11. Photonic mixer device according to one of claims 1 to 10, **characterized in that** the modulation gates (3, 4, 103, 104) are transparent for the incident electromagnetic radiation.

12. Photonic mixer device according to one of claims 1 to 11, **characterized in that** the modulation gates (3, 4, 103, 104) consist of a p- or n-doped semiconductor material.

13. Photonic mixer device according to one of claims 1 to 12, **characterized in that** the modulation gates (3, 4, 103, 104) are electrically isolated from the light-sensitive layer.

14. Photonic mixer device according to claim 13, **characterized in that** the modulation gates (102A - 102E) are electrically isolated by a silicon oxide layer (122) from the light-sensitive layer (105).

15. Photonic mixer device according to one of claims 1 to 14, **characterized in that** the electrode sections (1A - 1 E, 2A - 2E) of a readout electrode (1,2) spatially adjoin the modulation gates (3, 4).

16. Photonic mixer device according to one of claims 1 to 15, **characterized in that** an electric isolation layer (7) is provided between the contacts of the electrode sections of each readout electrode (1, 2).

17. Photonic mixer device according to one of claims 1 to 16, **characterized in that** the electrode sections of a readout electrode (101, 102) are spatially arranged in the area of the modulation gates (103, 104).

18. Photonic mixer device according to [one of claims] 1 to 17, **characterized in that** the contacts of the readout electrodes (101, 102) are electrically isolated from the modulation gates (103, 104).

19. Photonic mixer device according to one of claims 1 to 18, **characterized in that** two neighbouring mixer elements (213, 214, 215) of the detector have a common readout electrode (216, 217).

20. Photonic mixer device according to one of claims 1 to 19, **characterized in that** two neighbouring mixer elements (213, 214, 215) of the detector have a common modulation gate (218, 219).

21. Photonic mixer device according to one of claims 1 to 20, **characterized in that** at least two memory gates (323, 324) are provided which surround the readout electrodes (301, 302).

22. Photonic mixer device according to claim 21, **characterized in that** the memory gates (323, 324, 423, 424) are strip-shaped.

23. Photonic mixer device according to claim 21 or 22, **characterized in that** the memory gates (323, 324, 423, 424) are covered by a material that is not transparent for the incident electromagnetic radiation.

24. Photonic mixer device according to one of claims 21 to 23, **characterized in that** the memory gates (323, 324, 423, 424) are electrically isolated from the readout electrodes (301, 302, 401, 402).

25. Photonic mixer device according to one of claims 21 to 24, **characterized in that** the memory gates (323, 324, 423, 424) are electrically isolated from the photosensitive layer.

26. Photonic mixer device according to one of claims 21 to 25, **characterized in that** the memory gates (323, 324, 423, 424) are connected to an adjustable voltage source.

27. Photonic mixer device according to one of claims 21 to 26, **characterized in that** the memory gates (323, 324, 423, 424) are biased with a positive or negative electric voltage.

28. Photonic mixer device according to one of claims 21 to 27, **characterized in that** the memory gates (323, 324, 423, 424, 531, 532, 633) each form a separation gate.

29. Photonic mixer device according to one of claims 21 to 28, **characterized in that** the memory gates (323, 324, 423, 424) lie on a different potential from the readout electrodes (301, 302, 401, 402).

30. Photonic mixer device according to one of claims 21 to 29, **characterized in that** two neighbouring mixer elements (613, 614, 615) of the detector have a common memory gate (633).

31. Photonic mixer device according to one of claims 1 to 30, **characterized in that** it has at least one additional memory structure.

32. Photonic mixer device according to claim 31, **characterized in that**
- the memory structure has at least one readout electrode (427, 428) with a memory gate (425, 426) surrounding it,
- the readout electrodes (427, 428) having discrete electrode sections electrically connected to each other,
- the electrodes of the readout electrodes (427, 428) being electrically isolated from the memory gates (425, 426),
- the memory structure being covered by a layer that is not transparent for electromagnetic radiation, and
- the readout electrodes (427, 428) of the memory structure being electrically connected to the readout electrodes (401, 402) of the mixer elements.

33. Photonic mixer device according to claim 31 or 32, **characterized in that** exactly two memory structures are provided per mixer element.

34. Photonic mixer device according to one of claims 31 to 33, **characterized in that** two neighbouring mixer elements of the detector have a common memory structure.

35. Photonic mixer device according to one of claims 31 to 34, **characterized in that** the memory gates (425, 426) are connected to a second adjustable voltage source.

36. Photonic mixer device according to one of claims 31 to 35, **characterized in that** the memory gates (423, 424) of the mixer elements lie on a different potential from the memory gates (425, 426) of the memory devices.

37. Photonic mixer device according to one of claims 31 to 36, **characterized in that** the memory gates (425, 426) of the memory structures lie on a lower potential than the memory gates (423, 424) of the mixer elements and on a higher potential than the readout electrodes (401, 402) of the mixer elements.

## Revendications

1. Photodétecteur mixte avec une couche photosensible, au moins deux portes (3, 4, 103, 104, 203, 204, 303, 304, 403, 404) de modulation et au moins deux électrodes (1, 2, 101, 102, 201, 202, 301, 302, 401, 402, 501, 502, 601, 602) d'extraction reliées à la couche photosensible, les portes (3, 4, 103, 104, 203, 204, 303, 304, 403, 404) de modulation pouvant être reliées à un dispositif de modulation, lequel relève et abaisse le potentiel des portes de modulation relativement l'une par rapport à l'autre et relativement par rapport au potentiel de préférence constant des électrodes d'extraction conformément à une fonction de modulation souhaitée, **caractérisé en ce que** les électrodes (1, 2, 101, 102, 201, 202, 301, 302, 401, 402, 501, 502, 601, 602) d'extraction présentent respectivement au moins deux segments (1A-1 E, 2A-2E) d'électrode discrets disposés l'un à côté de l'autre.

2. Photodétecteur mixte selon la revendication 1, **caractérisé en ce que** les électrodes (1, 2, 101, 102, 201, 202, 301, 302, 401, 402, 501, 502, 601, 602) d'extraction présentent des contacts métalliques (20A-20E) de préférence en aluminium.

3. Photodétecteur mixte selon la revendication 1 ou 2, **caractérisé en ce que** la couche photosensible dans la zone sous les contacts métalliques des électrodes (1, 2, 101, 102, 201, 202, 301, 302, 401, 402, 501, 502, 601, 602) d'extraction est dotée de façon complémentaire au reste de la couche photosensible.

4. Photodétecteur mixte selon l'une des revendications 1 à 3, **caractérisé en ce que** les électrodes (1, 2, 101, 102, 201, 202, 301, 302, 401, 402, 501, 502, 601, 602) d'extraction sont des diodes pn.

5. Photodétecteur mixte selon l'une des revendications 1 à 4, **caractérisé en ce que** la longueur des segments (1A-1E, 2A-2E) d'électrode discrets des électrodes (1, 2, 101, 102, 201, 202, 301, 302, 401, 402, 501, 502, 601, 602) d'extraction est au maximum le triple, de préférence au maximum le double de leur largeur et surtout de préférence égale à leur largeur.

6. Photodétecteur mixte selon l'une des revendications 1 à 5, **caractérisé en ce que** la largeur des segments d'électrode discrets est de 0,5 micromètre à 5 micromètres, de préférence de 1 micromètre à 3 micromètres et surtout de préférence de 1,8 micromètre.

7. Photodétecteur mixte selon l'une des revendications 1 à 6, **caractérisé en ce que** les divers segments d'électrode d'une électrode (1, 2, 101, 102) d'extraction présentent un écart entre leurs bords latéraux compris entre 2 micromètres et 10 micromètres, de préférence entre 4 micromètres et 8 micromètres et surtout de préférence de 6 micromètres.

8. Photodétecteur mixte selon l'une des revendications 1 à 7, **caractérisé en ce que** la section transversale des contacts des électrodes (1, 2, 101, 102, 201, 202, 301, 302, 401, 402, 501, 502, 601, 602) d'extraction est en forme de T, les contacts surplombant en partie les couches de matériau attenantes.

9. Photodétecteur mixte selon l'une des revendications 1 à 8, **caractérisé en ce que** les segments (1A-1E, 2A-2E) d'électrode discrets sont respectivement reliés électriquement entre eux à une électrode (1, 2, 101, 102) d'extraction.

10. Photodétecteur mixte selon l'une des revendications 1 à 9, **caractérisé en ce que** les portes (3, 4, 103, 104) de modulation sont formées par des bandes parallèles entre elles qui, de préférence, s'étendent aussi pour l'essentiel parallèlement aux rangées des segments d'électrode discrets des électrodes d'extraction.

11. Photodétecteur mixte selon l'une des revendications 1 à 10, **caractérisé en ce que** les portes (3, 4, 103, 104) de modulation sont transparentes au rayonnement électromagnétique existant.

12. Photodétecteur mixte selon l'une des revendications 1 à 11, **caractérisé en ce que** les portes (3, 4, 103, 104) de modulation se composent d'un matériau semi-conducteur doté en p ou n.

13. Photodétecteur mixte selon l'une des revendications 1 à 12, **caractérisé en ce que** les portes (3, 4, 103, 104) de modulation sont électriquement isolées de la couche photosensible.

14. Photodétecteur mixte selon la revendication 13, **caractérisé en ce que** les portes (102A-102E) de modulation sont électriquement isolées de la couche photosensible (105) par une couche (122) d'oxyde de silicium.

15. Photodétecteur mixte selon l'une des revendications 1 à 14, **caractérisé en ce que** les segments (1A-1 E, 2A-2E) d'électrode d'une électrode (1, 2) d'extraction sont attenants dans l'espace aux portes (3, 4) de modulation.

16. Photodétecteur mixte selon l'une des revendications 1 à 15, **caractérisé en ce qu'**une couche (7) d'isolation électrique est prévue entre les contacts d'un segment d'électrode d'une chaque électrode (1, 2) d'extraction.

17. Photodétecteur mixte selon l'une des revendications 1 à 16, **caractérisé en ce que** les segments d'électrode d'une électrode (101, 102) d'extraction sont disposés dans l'espace dans la zone des portes (103, 104) de modulation.

18. Photodétecteur mixte selon l'une des revendications 1 à 17, **caractérisé en ce que** les contacts des électrodes (101, 102) d'extraction sont électriquement isolées des portes (103, 104) de modulation.

19. Photodétecteur mixte selon l'une des revendications 1 à 18, **caractérisé en ce que** deux éléments mélangeurs (213, 214, 215) voisins du détecteur présentent une électrode (216, 217) d'extraction commune.

20. Photodétecteur mixte selon l'une des revendications 1 à 19, **caractérisé en ce que** deux éléments mélangeurs (213, 214, 215) voisins du détecteur présentent une porte (218, 219) de modulation commune.

21. Photodétecteur mixte selon l'une des revendications 1 à 20, **caractérisé en ce qu'**au moins deux portes (323, 324) de mémorisation sont prévues, lesquelles enveloppent les électrodes (301, 302) d'extraction.

22. Photodétecteur mixte selon la revendication 21, **caractérisé en ce que** les portes (323, 324, 423, 424) de mémorisation sont en forme de bande.

23. Photodétecteur mixte selon la revendication 21 ou 22, **caractérisé en ce que** les portes (323, 324, 423, 424) de mémorisation sont recouvertes d'un matériau non transparent au rayonnement électromagnétique existant.

24. Photodétecteur mixte selon l'une des revendications 21 à 23, **caractérisé en ce que** les portes (323, 324, 423, 424) de mémorisation sont électriquement isolées des électrodes (301, 302, 401, 402) d'extraction.

25. Photodétecteur mixte selon l'une des revendications 21 à 24, **caractérisé en ce que** les portes (323, 324, 423, 424) de mémorisation sont électriquement isolées de la couche photosensible.

26. Photodétecteur mixte selon l'une des revendications 21 à 25, **caractérisé en ce que** les portes (323, 324, 423, 424) de mémorisation sont reliées à une source de tension réglable.

27. Photodétecteur mixte selon l'une des revendications 21 à 26, **caractérisé en ce que** les portes (323, 324, 423, 424) de mémorisation sont polarisées par une tension électrique positive ou négative.

28. Photodétecteur mixte selon l'une des revendications 21 à 27, **caractérisé en ce que** les portes (323, 324, 423, 424, 531, 532, 633) de mémorisation forment respectivement une porte de séparation.

29. Photodétecteur mixte selon l'une des revendications 21 à 28, **caractérisé en ce que** les portes (323, 324, 423, 424) de mémorisation sont sur un autre potentiel que les électrodes (301, 302, 401, 402) d'extraction.

30. Photodétecteur mixte selon l'une des revendications 21 à 29, **caractérisé en ce que** deux éléments mélangeurs (613, 614, 615) voisins du détecteur présentent une porte (633) de mémorisation commune.

31. Photodétecteur mixte selon l'une des revendications 1 à 30, **caractérisé en ce qu'**il présente au moins une structure de mémorisation supplémentaire.

32. Photodétecteur selon la revendication 31, **caractérisé en ce que**
- la structure de mémorisation présente au moins une électrode (427, 428) d'extraction avec une porte (425, 426) de mémorisation enveloppante,
- les électrodes (427, 428) d'extraction présentant des segments d'électrode discrets électriquement reliés entre eux,
- les électrodes des électrodes (427, 428) d'extraction étant électriquement isolées des portes (425, 426) de mémorisation,
- la structure de mémorisation étant recouverte d'une couche non transparente au rayonnement électromagnétique,
- les électrodes (427, 428) d'extraction de la structure de mémorisation sont électriquement reliées aux électrodes (401, 402) d'extraction des éléments mélangeurs.

33. Photodétecteur mixte selon la revendication 31 ou 32, **caractérisé en ce qu'**exactement deux structures de mémorisation sont prévues par élément mélangeur.

34. Photodétecteur mixte selon l'une des revendications 31 à 33, **caractérisé en ce que** deux éléments mélangeurs voisins du détecteur présentent une structure de mémorisation commune.

35. Photodétecteur mixte selon l'une des revendications 31 à 34, **caractérisé en ce que** les portes (425, 426) de mémorisation sont reliées à une deuxième source de tension réglable.

36. Photodétecteur mixte selon l'une des revendications 31 à 35, **caractérisé en ce que** les portes (423, 424) de mémorisation des éléments mélangeurs sont sur un autre potentiel que les portes (425, 426) de mémorisation des dispositifs de mémorisation.

37. Photodétecteur mixte selon l'une des revendications 31 à 36, **caractérisé en ce que** les portes (425, 426) de mémorisation des structures de mémorisation sont sur un potentiel plus bas que les portes (423, 424) de mémorisation des éléments mélangeurs et sur un potentiel plus élevé que les électrodes (401, 402) d'extraction des éléments mélangeurs.
